# EUROPEAN PATENT APPLICATION

(11) **EP 4 661 059 A1**
(43) Date of publication of application: **10.12.2025**
(21) Application number: 24770483.6
(22) Date of filing: 26.02.2024
(51) Int. Cl.: H01L 21/304, B24B 1/04, B24B 9/00

(54) **SEMICONDUCTOR WAFER GRINDING DEVICE AND GRINDING METHOD**

(30) Priority: 13.03.2023 JP 2023038203; 15.03.2023 JP 2023041200
(71) Applicant: Tokyo Seimitsu Co., Ltd., Hachioji-shi, Tokyo 192-8515 (JP)
(72) Inventor: TSURU, Taira, Tsuchiura-shi, Ibaraki 300-0015 (JP)
(74) Representative: Seemann & Partner Patentanwälte mbB
(86) International application number: PCT/JP2024/006692
(87) International publication number: WO 2024/190370

(57) **Abstract**

According to a semiconductor wafer grinding method including: a step of measuring a crystal orientation of an outer circumferential portion of at least one semiconductor wafer from among a plurality of semiconductor wafers cut from an ingot and storing the crystal orientation as crystal orientation data corresponding to circumferential displacement with respect to a reference position of the at least one semiconductor wafer; a step of grinding the at least one semiconductor wafer while changing a grinding condition including a direction and a frequency of ultrasonic application, based on the crystal orientation, and storing an effective grinding condition as learning data; a step of detecting a reference position of another semiconductor wafer and estimating a crystal orientation at a grinding position of the other semiconductor wafer, with reference to the crystal orientation data, based on the detected reference position; and a step of setting a grinding condition at the grinding position of the other semiconductor wafer, with reference to the learning data, and grinding an outer circumferential portion of the other semiconductor wafer under the grinding condition set to a grinding spindle, high-efficiency and high-yield machining to the circumferential edge portion of a semiconductor wafer can be achieved.

## Description

### Field

The present invention relates to a grinding device and a grinding method for grinding a semiconductor wafer and particularly relates to a semiconductor wafer grinding device and a semiconductor wafer grinding method suitable for grinding the outer circumferential edge portion of a semiconductor wafer.

### Background

It has been known that ultrasonic waves are applied to a grinding stone for flattening the front and back faces of a wafer cut from an ingot to prevent the grinding stone from being clogged during grinding. For example, a grinding device described in Patent Literature 1 includes a chuck table that holds a machining target and a grinding means that grinds the machining target held by the chuck table, in order to effectively apply ultrasonic vibrations to a grinding stone. Then, the grinding means includes a rotary spindle and a wheel provided to one end of the rotary spindle, in which a grinding wheel is attached to the wheel mount and includes a wheel base and a grinding stone mounted on the wheel base. An ultrasonic vibrator is provided to either the wheel mount or the grinding stone, and a power supply means is provided to the rotary spindle in order to apply power to the ultrasonic vibrator.

In addition, Patent Literature 2 states that, in order to favorably grind a wafer with a grinding stone to which ultrasonic vibrations are being transferred properly, a grinding wheel that grinds the wafer held by a holding table includes the following constituents. The constituents are a first annular plate mounted on a mount in a grinding device, a cylindrical body extending downward from the outer circumference of the first annular plate, a second annular plate coupled to the lower end of the cylindrical body, a grinding stone disposed annularly on the lower face of the second annular plate, an annular ultrasonic oscillator that is disposed on the upper face of the second annular plate and surrounds the opening, and an ultrasonic receiver that receives the ultrasonic vibrations transferred from the ultrasonic oscillator to the grinding stone.

As another example, Patent Literature 3 states that a wafer is ground with a grindstone to which ultrasonic vibrations are being applied. In this publication, for machining with as little damage as possible in terrace machining to a substrate, for example, without cracking the surface layer of the substrate, a chamfering device for grinding the end face of a machining target includes the following constituents. That is, the constituents are a vibratory flange fitted and fixed to the spindle of a grinding unit, a grindstone wheel that includes a grindstone on its outer circumferential lower face and is fitted to the vibratory flange, and a piezoelectric element that is provided on the bottom side of the grindstone wheel lower than the upper face of the grindstone on the outer circumferential side of the vibratory flange and vibrates ultrasonically radially. Thus, the end face of the machining target is subjected to terrace machining by radial incision with the grindstone to which the piezoelectric element is applying ultrasonic vibrations.

### Citation List

### Patent Literature

Patent Literature 1: Japanese Patent Application Laid-Open No. 2008-23693
Patent Literature 2: Japanese Patent Application Laid-Open No. 2018-47508
Patent Literature 3: Japanese Patent Application Laid-Open No. 2017-177251
Patent Literature 4: Japanese Patent Application Laid-Open No. 2021-141107
Patent Literature 5: Japanese Patent Application Laid-Open No. 2017-183503

### Non Patent Literature

Non Patent Literature 1: YAMADA, et al. "Precision laser slicing technology for single crystal SiC wafers, 2nd Report: Relationship between laser scanning direction and cleavage", Journal of the Japan Society for Abrasive Technology, Vol. 65, No. 10, pp. 549-555, October 2021

### Summary

### Technical Problem

In grinding a hard machining target like a silicon single-crystal wafer freshly cut from an ingot, from the viewpoint of an improvement in grinding efficiency and an improvement in yield, rough grinding, which is high-feed grinding having a high grinding load, and fine grinding, which is low in grinding load and is low in feed rate, are combined for the front and back faces of a wafer. Because grinding to the front and back faces of a wafer is plane grinding, for a single-crystal wafer, the feed direction of a grinding stone is made constant on the surface of the wafer, enabling grinding machining based on the same crystal orientation. As a result, the occurrence of a change in bonding state, such as cleavage, due to a variation in crystal orientation, can be avoided. That is, a stress applied to a wafer due to movement of a grindstone on the surface of the wafer is constant, theoretically, regardless of any place on the surface of the wafer, and thus uniform machining can be performed on the surface of the wafer, leading to a reduction in the frequency of occurrence of trouble, such as cracking.

In contrast to this, edge machining, which is machining to the side face of a wafer, corresponds to machining with a grinding stone rotating on the circumference of the wafer such that the edge has a tapered, arc, or arc-like cross-sectional shape, and thus the crystal orientation of the grinding part varies continuously. When the crystal orientation of a material having a crystal structure varies, the grinding load or grinding resistance of a grindstone changes even under the same grinding condition. Therefore, for grinding silicon wafers or the like, currently, a grinding condition, under which no defect occurs in the crystal orientation in which a defect occurs most easily, such as unintended cleavage, as defective grinding, is experientially obtained and then grinding is performed to each position in the circumferential direction of a wafer under a constant grinding condition. In this case, for example, in order to deal with a subtle change in strength on wafer records, a reduction in feed rate is required for the safest grinding condition to which the grinding condition is relaxed, and thus the capacity of machining equipment is not fully utilized. In a case where a behavior in the grinding resistance of a wafer is different from the expected behavior, a new grinding condition is required to be experientially determined.

In the grinding device described in Patent Literature 1, since ultrasonic vibrations are applied to the grinding stone, grinding debris, which stays as a cause of clogging between abrasive grains of the grinding stone after being generated due to grinding, is removed by flowage based on the micro-vibrations acting on the grinding stone, and thus even a brittle hard material can be ground efficiently. The grinding device certainly uses a method useful for plane grinding. However, a single-crystal wafer has its crystal orientation varying continuously on the circumferential side face of the wafer, leading to a change in the grinding stress to the wafer and a change in the grinding resistance to the wafer even under the same grinding condition. Therefore, for an improvement in grinding efficiency, a variable grinding condition is required to obtain a constant machining effect as a result without excessive grinding resistance.

As described in Patent Literature 2, in plane grinding to a wafer based on rough grinding and fine grinding in combination, an increased ultrasonic output increases the amplitude of the grindstone at the time of rough grinding and a reduced ultrasonic output causes the grindstone to have the target reduced amplitude in fine grinding, leading to an enhancement in machining efficiency. In the grinding device of Patent Literature 2, because of plane grinding, one target amplitude for rough grinding and one target amplitude for fine grinding are simply required to be set to the grinding stone. In grinding the outer circumferential edge of a wafer, the wafer has grinding resistance varying depending on circumferential position, and thus the grinding condition in which a single target amplitude is simply set to the grinding stone is not necessarily an optimum condition. For an improvement in grinding efficiency, desirably, a target amplitude for ultrasonic excitation is set depending on the circumferential position of the wafer.

According to Patent Literature 3, in chamfering a wafer or the like, ultrasonic vibrations are applied to the grinding stone to promote the inflow and outflow of coolant, so that cleaning of the ground face or discharge of grinding debris is promoted. The chamfering device described in Patent Literature 3 is not necessarily intended only for machining to single-crystal wafers but is intended for general-purpose chamfering machining. Thus, it can be thought that a safer (more relaxed) machining condition under which no trouble, such as cracking or chipping, occurs, is given such that machining can be performed regardless of the presence or absence of a change in the grinding resistance or internal stress in the circumferential direction of a machining target.

The present invention has been made in consideration of the disadvantages in the above-described conventional technologies, and an object of the present invention is to achieve high-efficiency and high-yield machining to the circumferential edge portion of a semiconductor wafer. Specifically, the above object is to achieve a machining method and a machining device that are capable of dealing, using ultrasonic vibration, with a change in bonding state, such as cleavage, due to a change in crystal orientation in beveling machining as outer circumferential chamfering machining. Another object is to achieve an enhancement in the machining efficiency of beveling machining and an enhancement in the precision of machining in the above object or easy application of ultrasonic vibration to existing chamfering devices, namely, to achieve at least one of the objects including the above object.

### Solution to Problem

According to a feature of the present invention that achieves the above objects, provided is a semiconductor wafer grinding device (wafer grinding device) capable of grinding an outer circumferential portion of a semiconductor wafer, the semiconductor wafer grinding device comprising: a table that bears the semiconductor wafer and is rotationally movable; a grinding spindle capable of grinding the outer circumferential portion of the semiconductor wafer; and a shape measurement device that is disposed out of contact with the semiconductor wafer and measures an outer shape of the semiconductor wafer, wherein the grinding spindle includes: a grinding stone for grinding the outer circumferential portion of the semiconductor wafer; an ultrasonic application means that performs ultrasonic application to the grinding stone; and an ultrasonic control means that controls at least either a direction or a frequency of the ultrasonic application by the ultrasonic application means, and the ultrasonic control means controls, based on a change in circumferential position between a feature part of the semiconductor wafer measured and detected by the shape measurement device and a grinding position, at least either the direction or the frequency of the ultrasonic application to the grinding stone at the grinding position.

In the feature, preferably, the ultrasonic control means controls, based on a difference in crystal orientation between the feature part and the grinding position, at least one of the direction, the frequency, and an intensity of the ultrasonic application to the grinding stone at the grinding position, and, desirably, the ultrasonic control means includes a storage means that stores crystal orientation data describing a relationship between the circumferential position and the crystal orientation of the semiconductor wafer with the feature part of the semiconductor wafer as a reference, and controls at least either the direction or the frequency of the ultrasonic application to the grinding stone at the grinding position with reference to the crystal orientation data stored in the storage means.

In addition, preferably, the storage means stores grinding condition data describing a relationship between the crystal orientation and a grinding condition, and the grinding condition includes a grinding rate and an incision amount of the grinding stone and further includes at least either the direction or the frequency of the ultrasonic application to the grinding stone.

According to another feature of the present invention that achieves the above objects, provided is a semiconductor wafer grinding method for grinding an outer circumferential portion of a semiconductor wafer placed on a turntable, the semiconductor wafer grinding method comprising: a step of measuring a crystal orientation of an outer circumferential portion of at least one semiconductor wafer from among a plurality of semiconductor wafers cut from an ingot and storing the crystal orientation as crystal orientation data corresponding to circumferential displacement with respect to a reference position of the at least one semiconductor wafer; a step of grinding the at least one semiconductor wafer with the crystal orientation measured while changing a grinding condition including a direction and a frequency of ultrasonic application, based on the crystal orientation, and storing an effective grinding condition as learning data; a step of detecting a reference position of another semiconductor wafer cut from the ingot and estimating a crystal orientation at a grinding position of the other semiconductor wafer, with reference to the crystal orientation data, based on the detected reference position; and a step of setting a grinding condition at the grinding position of the other semiconductor wafer, with reference to the learning data, and grinding an outer circumferential portion of the other semiconductor wafer under the grinding condition set to a grinding stone (grinding spindle).

According to still another aspect of the present invention that achieves the above objects, provided is a semiconductor wafer grinding method for grinding an outer circumferential portion of a semiconductor wafer placed on a turntable, the semiconductor wafer grinding method comprising: a step of measuring a crystal orientation of an outer circumferential portion of one semiconductor wafer from among a plurality of semiconductor wafers and storing the crystal orientation as crystal orientation data corresponding to circumferential displacement with reference to a reference position of the one semiconductor wafer; a step of detecting a reference position of another semiconductor wafer and estimating a crystal orientation at a grinding position of the other semiconductor wafer, with reference to the crystal orientation data, based on the detected reference position; a step of setting, with reference to a relationship between a crystal orientation and a grinding condition stored in advance as learning data, a grinding condition at the grinding position of the one semiconductor wafer; and a step of grinding an outer circumferential portion of the other semiconductor wafer with a grinding stone under the set grinding condition, wherein the set grinding condition includes at least either a direction or a frequency of ultrasonic application to the grinding stone and further includes a grinding rate and an incision amount of the grinding stone. Desirably, the one semiconductor wafer and the other semiconductor wafer are a plurality of single-crystal silicon wafers cut from an ingot and have the respective reference positions at which the respective crystal orientations are substantially identical to each other.

According to yet another aspect of the present invention, provided is a semiconductor wafer grinding device capable of grinding an outer circumferential portion of a wafer, the semiconductor wafer grinding device comprising: a grinding stone for grinding the outer circumferential portion of the wafer; and an ultrasonic application means that performs ultrasonic application to the grinding stone, wherein the grinding stone includes: a first grindstone disposed in a first direction in a thickness direction of the wafer; and a second grindstone disposed in a second direction opposite to the first direction in the thickness direction.

In the wafer grinding device, desirably, the first grindstone and the second grindstone overlap mutually in the thickness direction.

In addition, in the wafer grinding device, desirably, the grinding stone further includes a third grindstone located between the first grindstone and the second grindstone in the thickness direction.

### Advantageous Effects of Invention

According to the present invention, in a wafer outer circumferential grinding device, the direction or frequency of ultrasonic vibration to a grinding stone is changed in accordance with the circumferential position of a wafer attached to the grinding device, and thus grinding can be performed under a grinding condition changed in accordance with a change in the crystal orientation in the circumferential direction of the wafer, so that a change in the bonding state, such as cleavage, due to a change in the crystal orientation can be easily dealt with. In addition, in accordance with the circumferential position of the wafer, an optimum grinding condition can be applied to beveling machining with a grindstone axis inclined, and thus an improvement can be made in machining efficiency and application of an unreasonable machining condition can be avoided, leading to an improvement in the precision of machining and an improvement in yield. In addition, since the direction or frequency of ultrasonic vibration is simply changed in accordance with the circumferential position of the wafer, a conventional machining device including an ultrasonic excitation device can be used. Even in a case where an ultrasonic excitation device is added to an outer circumferential chamfering machining device to achieve a new outer circumferential grinding device, the addition of the ultrasonic excitation device is easy because the addition is similar to addition to a plane grinding device.

### Brief Description of Drawings

FIG. 1A is a block diagram of an embodiment of a grinding device according to the present invention.
FIG. 1B is a schematic top view of the grinding device illustrated in FIG. 1A.
FIG. 2 is a schematic front view of the grinding device illustrated in FIG. 1B.
FIG. 3A is a partial front view for describing chamfering grinding to a wafer using a grinding spindle included in the grinding device.
FIG. 3B is a partial front view illustrating another example of the grinding spindle.
FIG. 4 is a partial front view for describing an example of grinding the end face of a wafer flat.
FIG. 5 is a schematic top view for describing grinding to the end face of a wafer and verification (learning) of a grinding result.
FIG. 6 is a flowchart illustrating an embodiment of a grinding method according to the present invention.
FIG. 7 is a front view of an embodiment of a grinding device including a grinding stone device according to the present invention.
FIG. 8 is a schematic side view of an embodiment of the grinding stone device according to the present invention, in which FIG. 8(a) illustrates, as an example, two hat-shaped grindstones having their shafts in parallel and FIG. 8(b) illustrates, as an example, two hat-shaped grindstones having their shafts spaced in the circumferential direction of a wafer.
FIG. 9 is a schematic side view of another embodiment of the grinding stone device according to the present invention.
FIG. 10 is a schematic side view of still another embodiment of the grinding stone device according to the present invention.
FIG. 11 is a schematic side view of yet another embodiment of the grinding stone device according to the present invention.

### Description of Embodiments

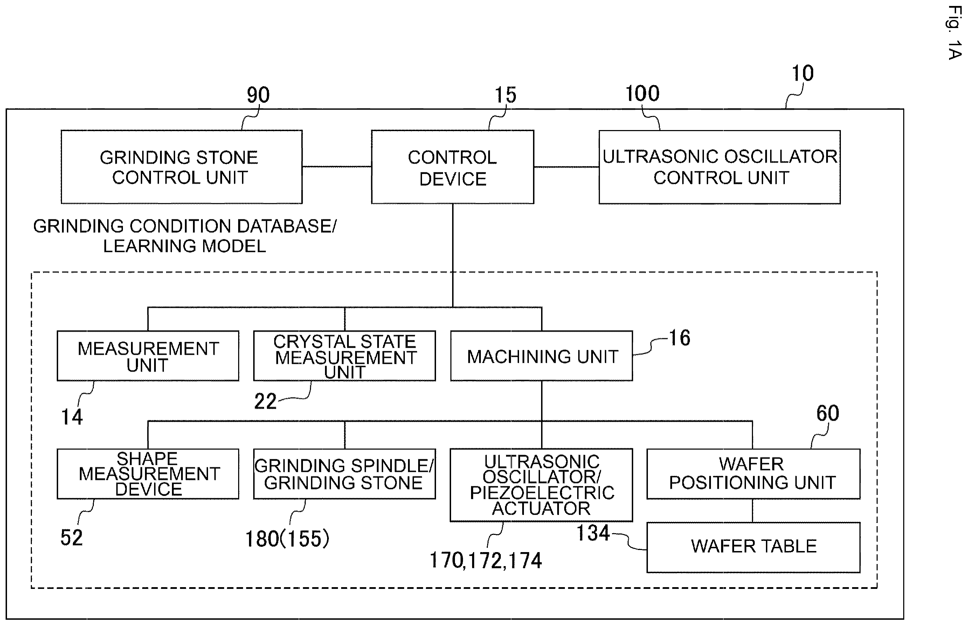

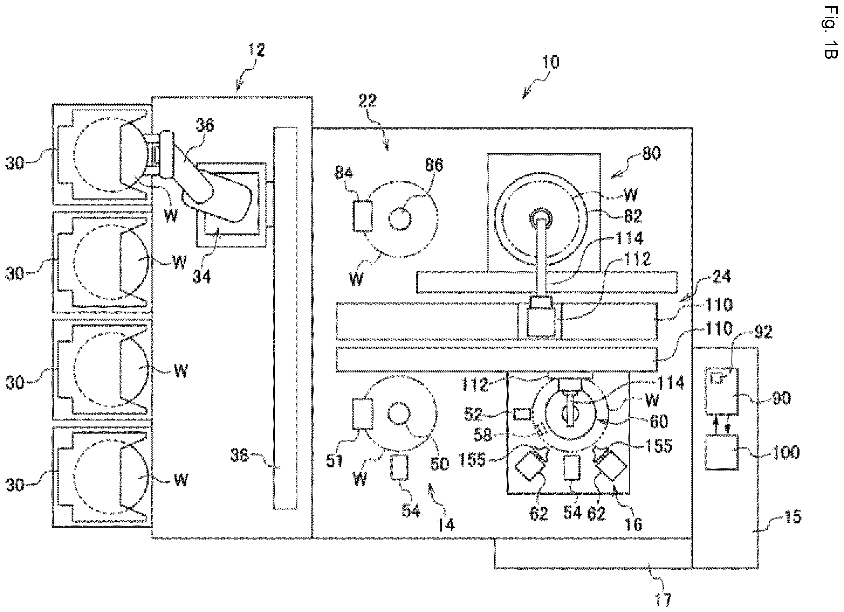

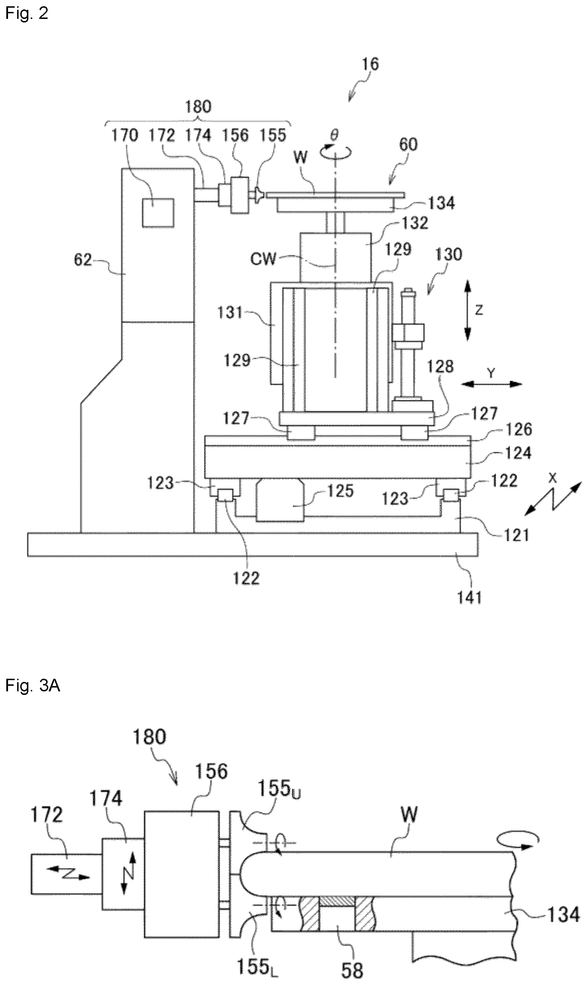

An embodiment of a semiconductor wafer grinding device according to the present invention (wafer grinding device 10) will be described below with the drawings. FIG. 1A is a block diagram of an embodiment of the wafer grinding device 10, and FIG. 1B is a schematic top view of the wafer grinding device 10. FIG. 2 is a front view of a machining unit 16 as a main part in the wafer grinding device 10 illustrated in FIGS. 1A and 1B.

The wafer grinding device 10 includes, as main constituent means, a supply collection unit 12 that supplies a wafer W to the wafer grinding device 10 and collects the wafer W from the wafer grinding device 10, a measurement unit 14 that detects a feature part, such as a notch or orientation flat, formed on the wafer W to be subjected to outer circumferential grinding and performs pre-alignment and pre-machining measurement, a machining unit 16 that performs grinding to the wafer W, a cleaning and drying unit 80 that cleans and dries the wafer W after the wafer W is ground, a crystal state measurement unit 22 that measures mainly the crystal orientation of the wafer W before and/or after the wafer W is ground, and a conveyance unit 24 that conveys the wafer W in an unmanned manner in the wafer grinding device 10. Each constituent means is controlled through an operation panel 17 and a control device 15.

The control device 15 includes an ultrasonic oscillator control unit 100 and a grinding stone control unit 90, which will be described in detail later. The grinding stone control unit 90 (learning model storage unit) stores a learning model, in which various programs and various types of data for processing using the learning model are stored in a storage means (memory) 92. For example, the control device 15 inputs an ultrasonic application condition and a grinding condition, determines whether the resultant edge shape of the wafer due to grinding under the ultrasonic application condition and the grinding condition fulfills a target edge shape, and generates a learning model. Note that the ultrasonic oscillator control unit 100 and the grinding stone control unit 90 may be provided to the machining unit 16.

In the supply collection unit 12, a number of wafers W cut from the same ingot are housed, as preparation, in a wafer cassette 30. In addition, after a wafer W subjected to chamfering machining is subjected to various types of measurement, the wafer W is collected to the wafer cassette 30 and then is conveyed to the following process. A supply collection robot 34 including a cassette table and a conveyance arm 36 is provided in order to move a wafer W from the wafer cassette 30 in the supply collection unit 12 to the measurement unit 14 or from the crystal state measurement unit 22 to the wafer cassette 30 in the supply collection unit 12. The conveyance arm 36 is capable of moving along a guide rail 38.

The measurement unit 14 measures the thickness of a wafer W to be subjected to chamfering machining, detects the orientation flat thereof, and performs pre-alignment thereto. The measurement unit 14 includes a measurement table 50, a thickness sensor 51, and an orientation flat detection sensor 54. The orientation flat detection sensor 54 corresponds to a laser sensor and detects the position of the orientation flat (feature part) of the wafer W.

Note that the measurement unit 14 is provided separately from the machining unit 16, which will be described later. This is because, at the time of grinding, grinding lubricant or the like may be used in the machining unit 16. In a case where grinding lubricant or the like is used, the grinding lubricant or the like is likely to adhere to the wafer W and the periphery thereof. In a case where, for example, an image (laser) sensor is used, since the measurement unit 14 is provided separately from the machining unit 16, more accurate measurement can be performed.

On the other hand, measurement can be performed in the machining unit 16 (in-process measurement). In this case, preferably, the measurement unit 14 includes a contact sensor and/or an eddy-current sensor that detects the position of the feature part of the wafer W.

The machining unit 16 corresponds to a main part in the wafer grinding device 10 and performs a process from rough machining to finish machining in outer circumferential grinding to the wafer W. The machining unit 16 includes a wafer positioning unit 60 and an outer circumferential grinding device 62. The wafer positioning unit 60 includes a wafer table 134 that holds the wafer W in a suction manner and is movable in the front-back direction (Y-axis direction), the left-right direction (X-axis direction), and the up-down direction (Z-axis direction) and rotatable around a central axis (θ axis) (FIG. 2). An AE sensor 58 is provided on the back face of the wafer table 134, and a shape measurement device 52 that measures the wafer's outer shape and an orientation flat detection sensor 54 are provided near the outer circumference of the wafer W. Note that, although the machining unit 16 includes the orientation flat detection sensor 54, in a case where the orientation flat is already detected in the measurement unit 14 and the positional coordinates thereof is referred to, the machining unit 16 may include no orientation flat detection sensor 54.

Specifically, the shape measurement device 52 is, for example, a laser displacement meter. In addition, a type of sensor and a type of measurement device for crystal state measurement, which will be described later, may be provided as options.

The cleaning and drying unit 80 cleans and dries the wafer W after grinding machining. While the wafer W held on a cleaning table 82 is being rotated, cleaning liquid is jetted to the surface of the wafer W to detach and remove the dirt adhering to the surface of the wafer W. Note that the wafer grinding device 10 may include no independent cleaning and drying unit 80. Any other unit in the wafer grinding device 10 may have a cleaning and drying function. No cleaning and drying function itself may be provided.

The crystal state measurement unit 22 measures the crystal state of the wafer W before and/or after chamfering machining. The crystal state measurement unit 22 includes a measurement table 86 that holds the wafer W and rotates and raises or lowers the wafer W and a crystal state measurement device 84 serving as an optical precision measurement device, such as a Raman microscope. Note that, for example, an AE sensor can be used for crystal state measurement.

The conveyance unit 24 conveys the wafer W to any of the units in the wafer grinding device 10. A transfer arm 114 is provided on each of slide blocks 112 and 112 slidable one-to-one along horizontal guides 110 and 110. The transfer arm 114 has its leading end to which a suction pad is attached and moves horizontally or vertically with the wafer W held in a suction manner.

Next, the configuration of the machining unit 16 as a feature part in the present invention will be described with FIG. 2. As described above, the machining unit 16 includes the wafer positioning unit 60 and the outer circumferential grinding device 62. The wafer positioning unit 60 includes an X table 124 movable in the X direction of FIG. 2 by an X-axis base 121 placed on a main base 141, an X-axis guide rail 122, an X-axis linear guide 123, and an X-axis drive means 125 including a ball screw and a servomotor. The X table 124 is incorporated with a Y table 128 movable in the Y direction of FIG. 2 by a Y-axis guide rail 126, a Y-axis linear guide 127, and a Y-axis drive means including a ball screw and a servomotor, which is not illustrated.

The Y table 128 has an upper portion incorporated with a Z table 131 movable in the Z direction of the drawing by a Z-axis drive means 130 including a ball screw and a stepping motor through guiding based on a Z-axis guide rail 129 and a Z-axis linear guide, which is not illustrated. The Z table 131 is incorporated with a θ-axis motor 132 and a θ spindle, and the wafer table 134 of a vacuum chuck type as a wafer holding means that bears a wafer W in a suction manner is attached to the θ spindle. The wafer positioning unit 60 rotates the wafer W in the θ direction and additionally moves the wafer W in the X, Y, or Z direction.

As illustrated in FIG. 1B, in the machining unit 16, two outer circumferential grinding devices 62 are spaced in the circumferential direction. In each outer circumferential grinding device 62, a spindle electric motor 156 has an axial end portion to which a grinding stone 155 is attached. A piezoelectric actuator 172 that ultrasonically excites the shaft of the spindle electric motor 156 horizontally and a piezoelectric actuator 174 that ultrasonically excites the shaft of the spindle electric motor 156 vertically are attached on the opposite side to the grindstone side of the spindle electric motor 156. The piezoelectric actuators 172 and 174 are connected to an ultrasonic oscillator 170. The grinding stone 155, the spindle electric motor 156, and the piezoelectric actuators 172 and 174 form a grinding spindle 180.

In the present embodiment having such a configuration as above, as the wafer W to be ground, a wafer W as a silicon wafer sliced from a single-crystal silicon ingot is used, and the diameter φ and thickness thereof are, respectively, approximately 50 to 300 mm and approximately 900 µm or less as an embodiment. Note that the material of the wafer W that can be searched for by the wafer grinding device 10 is not limited to the above. In particular, the wafer grinding device 10 is more suitable to SiC wafers expected to be used for power devices, for example. Although SiC is known as a difficult-to-machine material, according to the present embodiment, efficient grinding can be performed.

In general, in the case of a single-crystal wafer, the crystal orientation of the edge face (outer circumferential face) of the wafer W changes regularly in the circumferential direction, and thus the cleavage plane along which crystal cleavage proceeds is detected in advance using X-ray diffraction or a light figure method. As a pre-process, an orientation flat or a notch is formed as the positioning reference in advance to the wafer W at a predetermined angle to the detected cleavage plane. These pieces of data are stored in the grinding stone control unit 90 included in the control device 15.

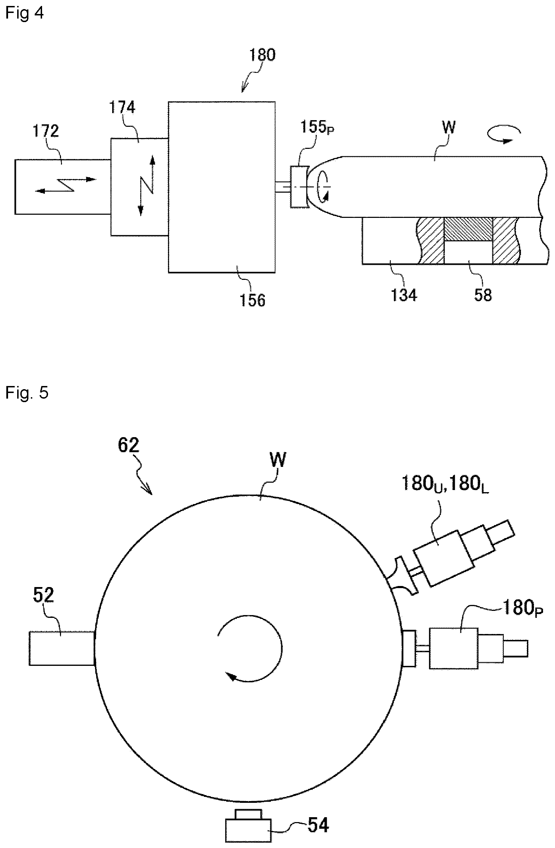

Next, outer circumferential grinding to a wafer W (chamfering) according to an embodiment of the present invention will be described with FIGS. 3A and 5. Grinding spindles 180 are attached to an outer circumferential grinding device 62 and are spaced in the up-down direction, in which one of the grinding spindles 180 includes a grinding stone 155_{U} and the other includes a grinding stone 155_{L}. A spindle electric motor 156 for the grinding spindles 180 has two mutually independent shafts, and the shafts have their leading ends to which the grinding stones 155_{U} and 155_{L} are attached as hat-shaped grindstones formed like bell mouths. Each shaft of the spindle electric motor 156 corresponds to a horizontal shaft.

In general, the shape of the outer circumferential face of a wafer W is like an arc in which the thickness of the wafer W increases radially inward from a central portion in the thickness direction (up-down direction) through the upper side and the lower side, and thus the grinding stones 155_{U} and 155_{L}, which rotate around their horizontal shafts, have prescribed cross-sectional shapes to form such a shape as above. In the present embodiment, the cross-sectional shape of each of the grinding stones 155_{U} and 155_{L} is conic (hat-shaped), in which its diameter increases from the leading end to the base. That is, the cross-sectional shape is like a bell mouth (like the shape of the "bell" part of a brass instrument). In other words, the grinding stones 155_{U} and 155_{L} each have a cross-sectional shape like a mountain tapering from the base (foot) to the leading end. Note that the driving of the θ-axis motor 132 included in the wafer positioning unit 60 causes the grinding position of the wafer W to change gradually in the circumferential direction.

The orientation flat detection sensor 54 capable of detecting the position of the orientation flat formed to the wafer W is disposed around the outer circumferential grinding device 62. Based on the position of the orientation flat detected by the orientation flat detection sensor 54, the circumferential position (coordinates) of the wafer W at the grinding position is determined. Based on the determined circumferential position (coordinates) at the grinding position, the crystal orientation at the grinding position is identified with reference to crystal orientation data stored in the grinding stone control unit 90. Note that the AE sensor 58 (FIGS. 1B and 3A) is attached to the wafer table 134 on which the wafer W is placed, and detects acoustic energy generated at the grinding position of the wafer W at the time of grinding machining to monitor the wafer W for plastic deformation, cracking, or abrasion at all times. Instead of such an AE sensor, a sensor, such as an acceleration sensor, may be provided to monitor vibrations generated in grinding machining.

The crystal orientation of the outer circumferential portion of the wafer W as a single-crystal wafer is inconstant and varies unlike those of the upper and lower flat portions, and thus grinding fails to be performed with the grinding direction along one crystal orientation. As described in Patent Literature 5 or Non Patent Literature 1, when the crystal orientation varies, the bonding state in the wafer W varies, so that the progress state of cleavage due to grinding machining varies. That is, when the wafer W is ground under a constant grinding condition (for example, the rotational rate of the grinding stone 155 is constant and the incision depth of the grinding stone 155 is constant), the wafer W has an area where the cleavage progresses and an area where the cleavage delays in progressing, resulting in a variation in the amount of generation of grinding debris. A reduction in grinding amount is required in order to maintain the precision of machining. In that case, a deterioration is made in grinding efficiency.

For solution to such disadvantages, according to the inventor, a grinding method based on crystal orientation is performed to set a grinding condition such that the progress of cleavage is uniform at the circumferential position of a wafer W, leading to an improvement in the precision of machining and an improvement in grinding efficiency. Note that, as a method, it can be thought that the rotational rate and incision depth of the grinding stone 155 are controlled based on the grinding position of the wafer W to obtain a result of uniform grinding, but the time required for grinding is likely to increase.

Thus, without changing the basic grinding condition of the grinding stone 155, in other words, without changing the operation state of the spindle electric motor 156 itself, the grinding spindle 180 including the spindle electric motor 156 is ultrasonically excited to change the grinding condition, substantially. Thus, a piezoelectric actuator 172 for horizontal (or axial) excitation and a piezoelectric actuator 174 for vertical excitation are attached on the opposite side to the grindstone side in the axial direction of the spindle electric motor 156. When a change is made in the level of ultrasonic excitation force that the piezoelectric actuators 172 and 174 each generate, as a result of combination of the respective ultrasonic excitation forces, the excitation force changed in level and direction is obtained, and then the obtained excitation force is applied from the grinding stone 155 to the wafer W to change the grinding condition, substantially.

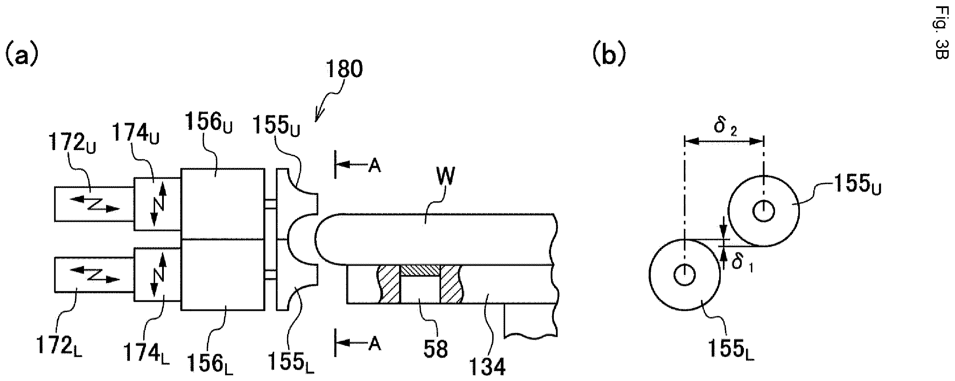

In the above embodiment, since the two grinding stones 155_{U} and 155_{L} identical in shape are spaced in the up-down direction, a slight gap is formed between the two grinding stones 155_{U} and 155_{L} to avoid any contact therebetween, leading to production of an unmachined beltlike part. This disadvantage can be solved by changing the circumferential positions of the two grinding stones 155_{U} and 155_{L}, FIG. 3B illustrates an example in which the unmachined part is eliminated.

FIG. 3B(a) is a front view illustrating the arrangement state of the grinding stones 155_{U} and 155_{L}, and FIG. 3B(b) is a schematic view that is taken along line A-A of FIG. 3B(a) and illustrates the arrangement state of the grinding stones 155_{U} and 155_{L}. As illustrated in FIG. 3B(a), the grinding stones 155_{U} and 155_{L} are disposed up and down in the thickness direction of the wafer W. In other words, the grinding stone 155_{U} is disposed higher than the central position of the thickness of the wafer W in the thickness direction of the wafer W, and the grinding stone 155_{L} is disposed lower than the central position of the thickness of the wafer W in the thickness direction of the wafer W. The grinding stones 155_{U} and 155_{L} are almost identical in shape, and the grinding stones 155_{U} and 155_{L} each enable grinding over the central portion in the thickness direction of the wafer W. That is, in a case where the machining unit 16 is viewed from the front (in a case where the two grinding stones 155_{U} and 155_{L} are viewed laterally), the two grinding stones 155_{U} and 155_{L} (or their grinding areas) overlap mutually in the thickness direction of the wafer W. In other words, note that, in a case where the machining unit 16 is viewed from the front (in a case where the two grinding stones 155_{U} and 155_{L} are viewed laterally), the respective grinding areas of the two grinding stones 155_{U} and 155_{L} may have no overlap with each other in the thickness direction of the wafer W. The lower end of the grinding stone 155_{U} and the upper ends of the grinding stones 155_{U} and 155_{L} may be spaced in the thickness direction of the wafer W. The grinding stones 155_{U} and 155_{L} are almost identical in shape but may be different in shape. As illustrated in FIG. 3B(b), the central positions of the two grinding stones 155_{U} and 155_{L} are different in position by δ₂ in the circumferential direction and are away from each other by δ₁ in the up-down direction. In other words, as illustrated in FIG. 3B(b) taken along line A-A, the two grinding stones 155_{U} and 155_{L} are disposed in a staggered manner. Thus, insufficient grinding can be avoided in outer circumferential grinding to the wafer W. Note that, in the embodiment illustrated in FIG. 3B, the grinding spindle 180 is ultrasonically excited to change the grinding conditions of the grinding stones 155_{U} and 155_{L}, substantially. Thus, a piezoelectric actuator 172 for horizontal (or axial) excitation and a piezoelectric actuator 174 for vertical excitation are attached on the opposite side to the grindstone side of the grinding spindle 180. Therefore, outer circumferential grinding to the wafer under the grinding condition varying depending on crystal orientation can be achieved.

FIG. 4 is a front view illustrating another example of the grinding stone 155. Regarding a grinding stone 155_{P} illustrated in FIG. 4, the number of grinding stone 155_{P} is one, differently from the above embodiment. The outer circumferential shape of a wafer W is changed from an arc shape in the above embodiment to a vertical face shape (namely, a cylindrical side shape). In a case where the angle of the edge between the upper face and outer circumferential face of the wafer W at the upper side portion of the wafer W and the angle of the edge between the lower face and outer circumferential face of the wafer W at the lower side portion of the wafer W are each 90°, for example, cracking occurs easily during handling, and thus machining is performed such that only areas extremely close to the upper and lower edges are rounded off, and most of the outer circumferential face is machined as a cylindrical face. The cross-sectional shape of the grinding stone 155_{P} is like a dish including arc-shaped parts that correspond to the areas near the upper and lower edges and are connected through a vertical line.

The curvature of each of the arcs-shaped parts, which correspond one-to-one to the upper and lower edges, in the grinding stone 155_{P} is smaller than the outer curvature of the wafer W (1/R, R: wafer's radius). Since such a shape of the grinding stone 155_{P} is set, even when the grinding stone 155_{P} rotates, any other part of the wafer W is not machined unintentionally. The grinding stone 155_{P} grinds the leading end portion of the wafer W. The grinding stone 155_{P} is disposed at a position between the two grinding stones 155_{U} and 155_{L} in the thickness direction of the wafer W. For example, the grinding stone 155_{P} is disposed at a position counter to the center of the thickness of the wafer W in the thickness direction of the wafer W. In the embodiment illustrated in FIG. 4, a piezoelectric actuator 172 for horizontal (or axial) excitation and a piezoelectric actuator 174 for vertical excitation are attached on the opposite side to the grindstone side of a grinding spindle 180 and apply ultrasonic waves to the grinding spindle 180 to change the grinding condition of the grinding stone 155_{P}, substantially. Thus, outer circumferential grinding to the wafer W under the grinding condition varying depending on crystal orientation can be achieved.

FIG. 5 illustrates, as an example, an outer circumferential grinding device 62 including a grinding spindle 180_{P} for cylindrical face grinding and two grinding spindles 180_{U} and 180_{L} for curved face grinding. The crystal orientation at the grinding position based on the position (coordinates) of the wafer measured by the shape measurement device 52 and the orientation flat detection sensor 54 is determined with reference to the crystal orientation data stored in the learning model storage unit (grinding stone control unit 90).

Note that, as described above, for example, the learning model and (training) data for use in machine learning are stored in the learning model storage unit. The data for use in machine learning includes an ultrasonic application condition, a grinding condition, and the resultant edge shape of the wafer under the conditions. The crystal orientation of the wafer depends on, for example, the material and (product) type of the wafer and the relationship therebetween is obvious. Thus, the crystal orientation at any position of the wafer is involved in the above data in advance for storage.

Based on the determined crystal orientation, the direction and frequency of ultrasonic excitation force to be generated by each piezoelectric actuator are determined, and the grinding spindles 180_{U}, 180_{L}, and 180_{P} each apply the corresponding determined excitation force to perform outer circumferential grinding. The grinding spindles 180_{U}, 180_{L}, and 180_{P} are each used properly, depending on machining information on the wafer W. Thus, outer circumferential grinding based on crystal orientation can be achieved over the entire circumference of the wafer W.

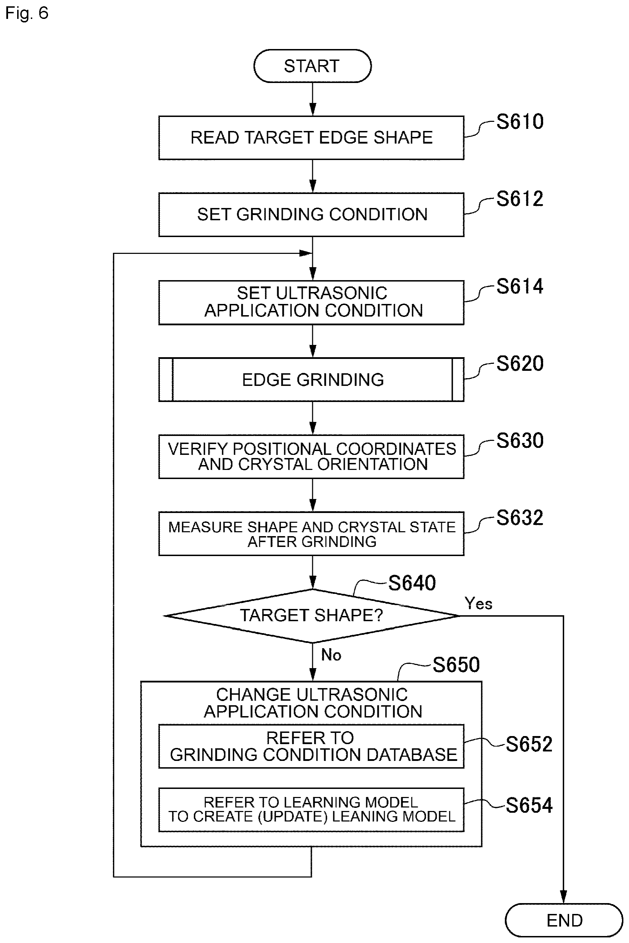

Next, an ultrasonic application method based on crystal orientation will be described with FIG. 6. The crystal orientation of a single-crystal wafer W varies in its outer circumferential portion, as described in Patent Literature 5. Thus, the direction and frequency of ultrasonic excitation force are changed, depending on the outer circumferential position of the wafer W. Based on the mechanical properties of crystalline material, the crystal direction of the wafer and the variation in the progress rate of cleavage are theoretically determined. However, the difference between reality and theory regarding the wafer W fails to be eliminated, and thus learning effect is used in the present embodiment.

In general, a number of wafers W cut from the same ingot have their formed orientation flats located at substantially the same crystal orientation. Thus, first, regarding one wafer W as a reference, a shape to result from machining (target edge shape) determined by the shape measurement device 52 with, as a reference, the orientation flat detected by the orientation flat detection sensor 54 is read in Step S610. Then, a grinding condition is provisionally set for the wafer W (Step S612). The provisional grinding condition is set based on the mechanical properties of crystalline material or based on the grinding result of a wafer W of the same type due to the previous grinding.

Based on the set grinding condition, an actual ultrasonic application condition is set (Step S614). An ultrasonic application effect due to driving of the piezoelectric actuators 172 and 174 is determined in advance based on preliminary testing or is set based on the previous grinding result of a wafer W of the same type.

After the grinding condition for the wafer W and the application condition for the piezoelectric actuators 172 and 174 are determined, actually, grinding machining (edge grinding) is performed to the outer circumference of the wafer W (Step S620). Here, during grinding, using both the AE sensor 58 and the shape measurement device 52, the positional coordinates of a grinding area and the crystal orientation corresponding thereto are verified and recorded (Step S630). When grinding to the entire outer circumference of the wafer W is finished, the shape and crystal state after the grinding are measured (Step S632). The measurement in Step S632 may be performed in the machining unit 16 (refer to FIG. 1B) or may be performed in the crystal state measurement unit 22 (refer to FIG. 1B).

Next, whether an outer circumferential grinding result of the wafer W fulfills the target shape presented in Step S610 is determined using a measurement result from the shape measurement device 52 or a measurement result of the crystal state (Step S640). In a case where the target shape is fulfilled, the grinding condition and the ultrasonic application condition at this time are stored, as grinding condition data, in the storage means 92 of the grinding stone control unit 90 (learning model storage unit) included in the control device 15. After that, using the grinding condition data, outer circumferential grinding is performed to another wafer W. At that time, for example, with the position of the orientation flat as a reference, the state at the grinding position, namely, the crystal orientation is determined.

In a case where the target shape is not fulfilled in Step S640, the ultrasonic application condition is changed (Step S650). Specifically, with reference to a grinding condition database (Step S652), the learning model is changed to create a new learning model (Step S654). Then, the processing goes back to Step S614 and then Steps S614 to S654 are repeated until the target edge shape (target outer circumferential shape) is achieved.

When once a learning model is created, using the data used in the model, outer circumferential grinding is performed to another wafer. At that time, in a case where the crystal orientation at the position of the orientation flat is different from the orientation stored in the learning model, the difference is corrected and then the model is employed. Note that, when the behavior of cleavage different from the data stored in the learning model is indicated during machining to a wafer W different from the wafer W as a reference, the data of the learning model can be updated at any time.

As described above, according to the embodiments of the present invention, in outer circumferential machining to the wafer W, the ultrasonic application condition is changed, depending on the machining position, and thus variation in the progress rate of cleavage due to a variation in crystal orientation can be controlled, so that uniform machining can be achieved. Thus, with an increase in machining efficiency, an enhancement is made in the yield based on outer circumferential machining to the wafer.

In addition, structurally, each employed grindstone is difficult for a cavity to form, and furthermore, due to a vibration effect using ultrasonic application, the grindstones can be easily inhibited from being clogged. Thus, grinding can be performed with the sharpness maintained, resulting in creation of a ground face with fewer irregularities.

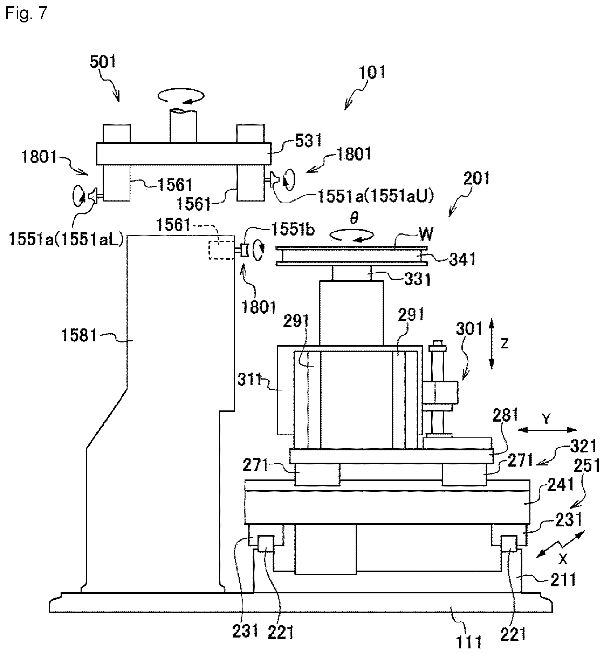

An embodiment of a grinding stone device 1801 according to the present invention will be described below with the drawings. FIG. 7 is a schematic front view of a wafer grinding device 101 including the grinding stone device 1801 according to the present embodiment. The wafer grinding device 101 includes a wafer holding unit 201, a grinding stone unit 501, and a wafer supply/housing unit, a wafer cleaning/drying unit, a wafer conveyance means, and a control unit that controls the operation of each constituent in the wafer grinding device 10, which are not illustrated.

The above grinding stone device has a structure in which a grinding stone for outer circumferential chamfering machining to a semiconductor wafer inhibits grinding debris from staying at the grinding machining position. According to a grinding stone disclosed below, even when ultrasonic excitation is applied to the grinding stone, outer circumferential chamfering machining can be performed at a high throughput.

The wafer holding unit 201 includes an X table 241 movable in the X direction of the drawing by an X-axis base 211 placed on a main base 111, two X-axis guide rails 221, four X-axis linear guides 231, and an X-axis drive mechanism 251 including a ball screw and a stepping motor.

The X table 241 is incorporated with a Y table 281 movable in the Y direction of the drawing by two Y-axis guide rails (not illustrated), four Y-axis linear guides 271, and a Y-axis drive mechanism 321 including a ball screw and a stepping motor, which are not illustrated.

The Y table 281 is incorporated with a Z table 311 movable in the Z direction of the drawing by a Z-axis drive mechanism 301 including a ball screw and a stepping motor through guiding based on two Z-axis guide rails 291 and four Z-axis linear guides not illustrated.

The Z table 311 is incorporated with a rotary spindle 331, and a wafer table 341 that bears a wafer W in a suction manner is attached to the rotary spindle 331. The wafer table 341 rotates around the axis of rotation. In the wafer holding unit 201, the wafer W is rotated in the θ direction and is translated in the X, Y, and Z direction to position the machining position set to the wafer W to the grinding stone unit 501, which will be described later.

In the grinding stone unit 501, a turntable 531 is disposed on the upper side and a grindstone base 1581 is disposed on the lower side. A pair of grinding stone devices 1801 are attached to the turntable 531, and one of the pair of grinding stone devices 1801 includes a grinding stone 1551a (1551aU) for grinding the outer circumferential portion of the (semiconductor) wafer W and a grinding spindle (spindle motor 1561) and the other includes a grinding stone 1551a (1551aL) for grinding the outer circumferential portion of the (semiconductor) wafer W and a grinding spindle (spindle motor 1561). The grinding stone 1551aU grinds the outer circumferential upper portion of the wafer W and the grinding stone 1551aL grinds the outer circumferential lower portion of the wafer W. Referring to FIG. 1, the turntable 531 rotates along a horizontal plane. For grinding the outer circumferential upper portion of the wafer W, the grinding stone 1551aU is simply required to come close to the wafer W (as in FIG. 1). For grinding the outer circumferential lower portion of the wafer W, the turntable 531 is simply required to rotate a half turn to make the grinding stone 1551aL close to the wafer W.

Note that, for the grinding stone devices 1801, the two grinding spindles are provided on the turntable 531, and the grinding stones 1551a (1551aU) and 1551a (1551aL) are disposed one-to-one on the two grinding spindles, but the arrangement of the grinding stones 1551a is not limited to the above. In addition, for such a grinding stone device 1801, no turntable 531 may be provided.

For example, a grinding stone device may include the grinding stones 1551a (1551aU) and 1551a (1551aL) arrayed up and down through a predetermined clearance and a single grinding spindle including individual spindle motors 1561.

The respective grinding stones 1551a included in the grinding stone devices 1801 disposed on the turntable 531 are hat-shaped grinding stones 1551a (1551aU and 1551aL) that are formed like bell mouths and are capable of grinding the circumferential edge portion of the wafer to an elliptically curved face.

The grindstone base 1581 disposed on the lower side of the grinding stone unit 501 has an upper portion to which a grinding stone device 1801 having its rotary shaft disposed horizontally is attached facing the wafer W. A dish-shaped grinding stone 1551b as a grindstone for flattening that grinds the circumferential edge of the wafer W to an almost vertical face (cylindrical face) is attached to the grinding stone device 1801 attached to the grindstone base 1581. Obviously, as a grindstone for a grinding stone device 1801 attached to the grindstone base 1581 or the turntable 531, in consideration of the purpose of machining and machining time, a hat-shaped grinding stone 1551a or a dish-shaped grinding stone 1551b can be selectively used.

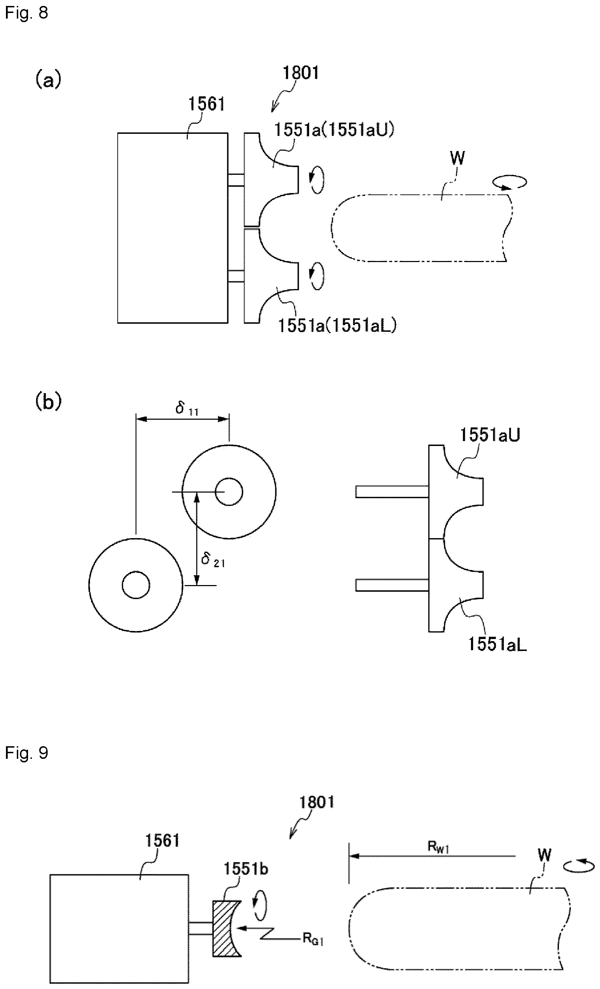

FIG. 2 illustrates details of a hat-shaped grinding stone 1551a. FIG. 8(a) illustrates an example in which two parallel horizontal shafts have their leading ends at which hat-shaped grinding stones 1551a are disposed one-to-one, and is a side view of the hat-shaped grinding stones 1551a. Each grinding stone 1551a is shaped like a hat to fit the cross-sectional shape of a wafer W as a machining target and is shaped to form a curved face like a smooth arc from the center in the thickness direction of the cross-sectional shape of the wafer W such that the thickness of the wafer W varies. That is, the grinding stones 1551a are each formed like a bell mouth that has a smaller diameter at an end closer to the wafer W and widens toward a spindle motor 1561. In other words, the grinding stones 1551a each have a shape in which curvature is given to the slant surface of a cone or a truncated cone or are each shaped like the "bell" part, which gradually widens, as the leading end portion of a brass instrument.

The grinding stones 1551a are not particularly limited in size. However, in terms of an increase in the degree of freedom of layout of a device, in particular, in terms of installation into a limited narrow space, with respect to the diameter of the wafer W as a grinding target, the diameter of each grinding stone 1551a (maximum diameter in the rotational direction) is preferably 0.1 or more, more preferably, 0.2 or more, and preferably 1.0 or less, more preferably, 0.5 or less, further preferably, 0.3 or less.

The two grinding stones 1551aU and 1551aL disposed up and down are substantially identical in outer shape. Therefore, their axes of rotation are disposed at equal distances from the center in the thickness direction of the wafer W, so that the outer circumferential face of the wafer W is subjected to grinding machining, symmetrically In the up-down direction. However, referring to FIG. 2(a), in order to avoid interference between the operations of the grinding stones 1551aU and 1551aL disposed up and down, a slight gap is required to be formed between the grinding stones 1551aU and 1551aL. As a result, an area not to be subjected to machining is formed in the central portion in the thickness direction of the wafer W.

As a simplest method to solve such a disadvantage, as illustrated in FIG. 8(b), the respective grinding positions of the two grinding stones 1551aU and 1551aL are made overlapped. More specifically, the two grinding stones 1551aU and 1551aL are disposed at different positions in the circumferential direction of the wafer W to avoid interference between the grinding stones 1551aU and 1551aL (that is, the grinding stones 1551aU and 1551aL are disposed in a staggered manner). Referring to FIG. 8(b), the inter-axis distance in the circumferential direction of the wafer W and the inter-axis distance in the thickness direction of the wafer between the upper grinding stone 1551aU and the lower grinding stone 1551aL are δ₁₁ and δ₂₁, respectively, and are larger than the thickness of the wafer W and their grinding areas overlap mutually. Thus, any area in which no grinding is performed can be avoided.

FIG. 9 is a laterally sectional view illustrating, as another example, a grinding stone 1551b for grinding the outer circumferential face of a wafer. The grinding stone 1551b is used in a case where the outer circumferential face of the wafer W is required to be flat. In a case where plane grinding is performed in outer circumferential grinding to the wafer W, when an upper side portion as a boundary with the upper face and a lower side portion as a boundary with the lower face are each made angled, the probability of occurrence of cracking or the like in the upper or lower side portion rises due to conveyance between wafer processing steps or handling in a processing step.

Considering such a disadvantage, a cross-sectional shape is determined for the grinding stone 1551b for plane grinding. Specifically, a part for machining most of the wafer W in the thickness direction (the central portion of the grinding stone 1551b) is made flat, namely, linear, or curved with curvature R_{G}, and a part for machining the upper and lower side portions (the outer end portion of the grinding stone 1551b) is made curved like a smooth arc. Then, the curvature of the curved part is made smaller than the outer curvature of the wafer W 1/Rw1). Thus, the grinding stone 1551b for plane grinding can be prevented from causing deviation from a desired shape due to unintentional interference with the wafer W. Note that the grinding stone 1551b can be used for post-machining to an area not to be machined in the central portion in the thickness direction of the wafer W due to the slight gap between the grinding stones 1551aU and 1551aL disposed up and down in FIG. 2(a) described above.

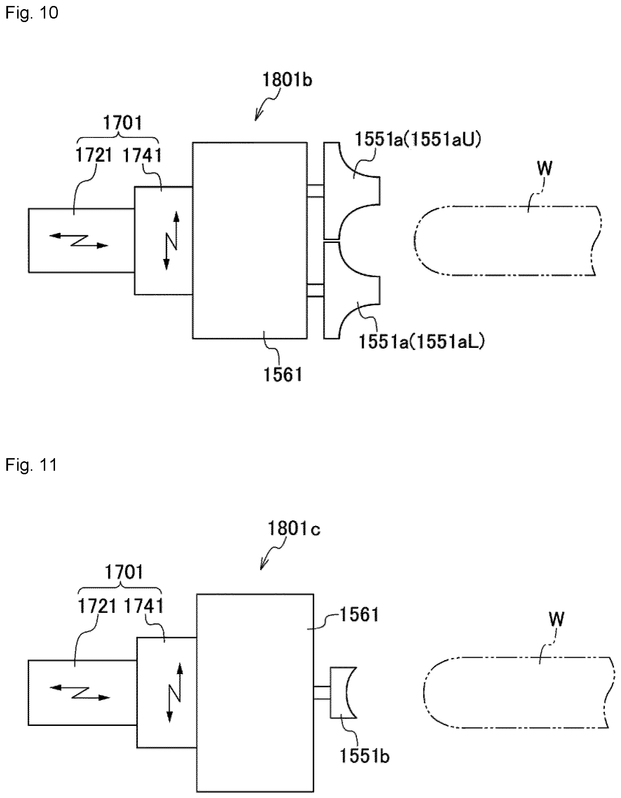

FIG. 10 illustrates, as an example, a grinding stone device 1801b including the grinding stones 1551a illustrated in FIG. 8 and an ultrasonic application means 1701 in combination, and FIG. 11 illustrates, as an example, a grinding stone device 1801c including the grinding stone 1551b illustrated in FIG. 9 and an ultrasonic application means 1701 in combination. FIG. 10 illustrates an example of a hat-shaped grindstone, and FIG. 11 illustrates an example of a dish-shaped grindstone. The crystal orientation of a wafer W varies in the circumferential direction. In particular, in a case where the wafer W is a single-crystal wafer, the variation is noticeable. As described in Non Patent Literature 1, in a case where the crystal orientation at the machining position of a wafer W varies, even when grinding is performed under the same grinding condition, the progress of cleavage varies, and thus the grinding amount is significantly larger or smaller than the expected grinding amount. Thus, in order to change the grinding condition, substantially, without changing the grinding condition, such as the rotational rate of a spindle motor 1561 coupled with a grinding stone, a piezoelectric actuator 1721 for axial excitation and a piezoelectric actuator 1741 for vertical excitation are provided to the spindle motor 1561 for each of the grinding stone devices 1801b and 1801c. For a change in each of the grinding condition of the grinding stones 1551a and the grinding condition of the grinding stone 1551b, the piezoelectric actuators 1721 and 1741 are controlled to change the direction and frequency of ultrasonic application. Thus, variation in the rate of cleavage can be controlled, so that a result of uniform grinding in the circumferential direction of the wafer can be obtained.

As understood from the arrangement of the grinding stones 1551a and 1551b and the works W in FIGS. 9 and 10, the grinding stones 1551a and 1551b are each different in rotational direction from the corresponding work W.

Conventionally, in grinding a work W by a grinding stone, the grinding stone and the work W are identical in rotational direction (rotate in the same plane). According to this conventional configuration, striated irregularities called "streaks" may be produced on the surface of the work W after grinding.

For solution to this, a technique called "helical grinding" may be employed, in which the rotational direction of a grinding stone is relatively slightly inclined to inhibit streaks from being produced.

A semiconductor wafer grinding stone device of the present invention is a technology enabling inhibition of streaks from being produced, based on an approach different from "helical grinding". Use of the grinding stones 1551a and 1551b different in shape from conventional grinding stones enables a state where the rotational direction of the work W is different from the rotational directions of the grinding stones 1551a and 1551b. Thus, similarly to "helical grinding", streaks are inhibited from being produced.

Due to ultrasonic excitation, striated irregularities can be further inhibited from being produced on the surface. The resultant surface has a more uniform state (e.g., an orange peel state).

In addition, for example, depending on the type of product and the type of post-process, there are various requirements for the edge shape and surface state of the wafer W. Instead of a simply flat surface, a surface having predetermined surface roughness may be a target after grinding. Additional use of ultrasonic excitation is preferable because not only streaks can be further inhibited from being produced but also control along the target surface state after grinding can be made easier.

In the above description, a silicon single-crystal wafer W is assumed as the wafer W to be ground, but the wafer is not limited to a silicon single-crystal wafer and thus may be a wafer made of another material, such as lithium tantalate or lithium niobate, or a polycrystalline wafer, obviously.

### Notes

(1) A semiconductor wafer grinding stone device provided to a semiconductor wafer grinding device, the semiconductor wafer grinding stone device including a grindstone for grinding a circumferential edge portion of a semiconductor wafer, the semiconductor wafer grinding stone device comprising:
   a rotary drive means that has one end side provided with the grindstone and drives the grindstone rotationally; and a machining means that controls a rotation and an incision amount of the grindstone, wherein the rotary drive means is disposed such that the grindstone is rotatable around an axis counter to a thickness direction of the semiconductor wafer.
(2) The semiconductor wafer grinding stone device according to Note 1, wherein a pair of the rotary drive means are provided, the rotary drive means each have an end portion provided with the grindstone and are each capable of rotating the grindstone around an axis orthogonal to the thickness direction of the semiconductor wafer, and the grindstones are each bell-mouth-shaped to grind an upper half or a lower half of the circumferential edge portion of the semiconductor wafer.
(3) The semiconductor wafer grinding stone device according to Note 2, wherein the pair of the grindstones are disposed at mutually different circumferential positions with respect to the semiconductor wafer.
(4) The semiconductor wafer grinding stone device according to Note 3, wherein the pair of the grindstones are disposed such that the pair of the grindstones are capable of grinding while overlapping each other in an up-down direction of the semiconductor wafer.
(5) The semiconductor wafer grinding stone device according to Note 1, wherein the rotary drive means is disposed such that the grindstone is rotatable around an axis orthogonal to the thickness direction of the semiconductor wafer, and an axial end face of the grindstone is a flat face or a concave face having a curvature smaller than an outer curvature of the semiconductor wafer as a grinding target.
(6) The semiconductor wafer grinding stone device according to Note 1, wherein the grindstone is provided with an ultrasonic application means that performs ultrasonic application, the machining means that controls the rotation and the incision amount of the grindstone, and an ultrasonic control means that controls at least either a direction or a frequency of the ultrasonic application by the ultrasonic application means.
(7) The semiconductor wafer grinding stone device according to Note 2, wherein the grindstones are each provided with an ultrasonic application means that performs ultrasonic application, the machining means that controls the rotation and the incision amount of the grindstone, and an ultrasonic control means that controls at least either a direction or a frequency of the ultrasonic application by the ultrasonic application means.
(8) The semiconductor wafer grinding stone device according to Note 5, wherein the grindstone is provided with an ultrasonic application means that performs ultrasonic application, the machining means that controls the rotation and the incision amount of the grindstone, and an ultrasonic control means that controls at least either a direction or a frequency of the ultrasonic application by the ultrasonic application means.

### Reference Signs List

10, 101 WAFER GRINDING DEVICE
12 SUPPLY COLLECTION UNIT
14 MEASUREMENT UNIT
15 CONTROL DEVICE
16 MACHINING UNIT
17 OPERATION PANEL
22 CRYSTAL STATE MEASUREMENT UNIT
30 WAFER CASSETTE
34 SUPPLY COLLECTION ROBOT
36 CONVEYANCE ARM
38 GUIDE RAIL
50 MEASUREMENT TABLE
51 THICKNESS SENSOR
52 SHAPE MEASUREMENT DEVICE
54 ORIENTATION FLAT DETECTION SENSOR
58 AE SENSOR
60 WAFER POSITIONING UNIT
62 OUTER CIRCUMFERENTIAL GRINDING DEVICE
80 CLEANING AND DRYING UNIT
82 CLEANING TABLE
84 CRYSTAL STATE MEASUREMENT DEVICE
86 MEASUREMENT TABLE
90 GRINDING STONE CONTROL UNIT
92 STORAGE MEANS (MEMORY)
100 ULTRASONIC OSCILLATOR CONTROL UNIT
110 HORIZONTAL GUIDE
111 MAIN BASE
112 SLIDE BLOCK
114 TRANSFER ARM
121, 211 X-AXIS BASE
122, 221 X-AXIS GUIDE RAIL
123, 231 X-AXIS LINEAR GUIDE
124, 241 X TABLE
125, 251 X-AXIS DRIVE MEANS
126 Y-AXIS GUIDE RAIL
127, 271 Y-AXIS LINEAR GUIDE
128, 281 Y TABLE
321 Y-AXIS DRIVE MECHANISM
129, 291 Z-AXIS GUIDE RAIL
130 Z-AXIS DRIVE MEANS
301 Z-AXIS DRIVE MECHANISM
131, 311 Z TABLE
132 θ-AXIS MOTOR
134, 341 WAFER TABLE
141 MAIN BASE
155, 155_{U}, 155_{L} GRINDING STONE
156, 156_{U}, 156_{L} SPINDLE ELECTRIC MOTOR
170 ULTRASONIC OSCILLATOR
172, 172_{U}, 172_{L} PIEZOELECTRIC ACTUATOR (HORIZONTAL EXCITATION)
174, 174_{U}, 174_{L} PIEZOELECTRIC ACTUATOR (VERTICAL EXCITATION)
180, 180_{U}, 180_{L} GRINDING SPINDLE
W WAFER
δ₁, δ₂₁ VERTICAL DEVIATION
δ₂, δ₁₁ CIRCUMFERENTIAL DEVIATION
201 WAFER HOLDING UNIT
311 ROTARY SPINDLE
501 GRINDING STONE UNIT
531 TURNTABLE
1551a, 1551aU, 1551aL (HAT-SHAPED OR BELL-MOUTH-SHAPED) GRINDING STONE
1551b (DISH-SHAPED) GRINDING STONE
1561 SPINDLE MOTOR
1581 GRINDSTONE BASE
1701 ULTRASONIC APPLICATION MEANS
1721 PIEZOELECTRIC ACTUATOR (FOR HORIZONTAL OR AXIAL EXCITATION)
1741 PIEZOELECTRIC ACTUATOR (FOR VERTICAL EXCITATION)
1801, 1801b, 1801c GRINDING STONE DEVICE

## Claims

1. A semiconductor wafer grinding device capable of grinding an outer circumferential portion of a semiconductor wafer, the semiconductor wafer grinding device comprising:
a table that bears the semiconductor wafer and is rotationally movable; a grinding spindle capable of grinding the outer circumferential portion of the semiconductor wafer; and a shape measurement device that is disposed out of contact with the semiconductor wafer and measures an outer shape of the semiconductor wafer, wherein
the grinding spindle includes: a grinding stone for grinding the outer circumferential portion of the semiconductor wafer; an ultrasonic application means that performs ultrasonic application to the grinding stone; and an ultrasonic control means that controls at least either a direction or a frequency of the ultrasonic application by the ultrasonic application means, and
the ultrasonic control means controls, based on a change in circumferential position between a feature part of the semiconductor wafer measured and detected by the shape measurement device and a grinding position, at least either the direction or the frequency of the ultrasonic application to the grinding stone at the grinding position.

2. The semiconductor wafer grinding device according to claim 1, wherein the ultrasonic control means controls, based on a difference in crystal orientation between the feature part and the grinding position, at least one of the direction, the frequency, or an intensity of the ultrasonic application to the grinding stone at the grinding position.

3. The semiconductor wafer grinding device according to claim 2, wherein the ultrasonic control means includes a storage means that stores crystal orientation data describing a relationship between the circumferential position and the crystal orientation of the semiconductor wafer with the feature part of the semiconductor wafer as a reference, and controls at least either the direction or the frequency of the ultrasonic application to the grinding stone at the grinding position with reference to the crystal orientation data stored in the storage means.

4. The semiconductor wafer grinding device according to claim 3, wherein the storage means stores grinding condition data describing a relationship between the crystal orientation and a grinding condition, and the grinding condition includes a grinding rate and an incision amount of the grinding stone and further includes at least either the direction or the frequency of the ultrasonic application to the grinding stone.

5. A semiconductor wafer grinding method for grinding an outer circumferential portion of a semiconductor wafer placed on a turntable, the semiconductor wafer grinding method comprising:
a step of measuring a crystal orientation of an outer circumferential portion of at least one semiconductor wafer from among a plurality of semiconductor wafers cut from an ingot and storing the crystal orientation as crystal orientation data corresponding to circumferential displacement with respect to a reference position of the at least one semiconductor wafer;
a step of grinding the at least one semiconductor wafer with the crystal orientation measured while changing a grinding condition including a direction and a frequency of ultrasonic application, based on the crystal orientation, and storing an effective grinding condition as learning data;
a step of detecting a reference position of another semiconductor wafer cut from the ingot and estimating a crystal orientation at a grinding position of the other semiconductor wafer, with reference to the crystal orientation data, based on the detected reference position; and
a step of setting a grinding condition at the grinding position of the other semiconductor wafer, with reference to the learning data, and grinding an outer circumferential portion of the other semiconductor wafer under the grinding condition set to a grinding spindle.

6. A semiconductor wafer grinding method for grinding an outer circumferential portion of a semiconductor wafer placed on a turntable, the semiconductor wafer grinding method comprising:
a step of measuring a crystal orientation of an outer circumferential portion of one semiconductor wafer from among a plurality of semiconductor wafers and storing the crystal orientation as crystal orientation data corresponding to circumferential displacement with reference to a reference position of the one semiconductor wafer;
a step of detecting a reference position of another semiconductor wafer and estimating a crystal orientation at a grinding position of the other semiconductor wafer, with reference to the crystal orientation data, based on the detected reference position;
a step of setting, with reference to a relationship between a crystal orientation and a grinding condition stored in advance as learning data, a grinding condition at the grinding position of the one semiconductor wafer; and
a step of grinding an outer circumferential portion of the other semiconductor wafer with a grinding stone under the set grinding condition, wherein
the set grinding condition includes at least either a direction or a frequency of ultrasonic application to the grinding stone and further includes a grinding rate and an incision amount of the grinding stone.

7. The semiconductor wafer grinding method according to claim 6, wherein the one semiconductor wafer and the other semiconductor wafer are a plurality of single-crystal silicon wafers cut from an ingot and have the respective reference positions at which the respective crystal orientations are substantially identical to each other.

8. A semiconductor wafer grinding device capable of grinding an outer circumferential portion of a wafer, the semiconductor wafer grinding device comprising:
a grinding stone for grinding the outer circumferential portion of the wafer; and
an ultrasonic application means that performs ultrasonic application to the grinding stone, wherein
the grinding stone includes: a first grindstone disposed in a first direction in a thickness direction of the wafer; and a second grindstone disposed in a second direction opposite to the first direction in the thickness direction.

9. The semiconductor wafer grinding device according to claim 8, wherein the first grindstone and the second grindstone overlap mutually in the thickness direction.

10. The semiconductor wafer grinding device according to claim 9, wherein the grinding stone further includes a third grindstone located between the first grindstone and the second grindstone in the thickness direction.
